(19) Europäisches Patentamt
European Patent Office
Office européen des brevets

(11) **EP 2 779 030 B1**

(12) **EUROPÄISCHE PATENTSCHRIFT**

(45) Veröffentlichungstag und Bekanntmachung des Hinweises auf die Patenterteilung:
**08.07.2020   Patentblatt 2020/28**

(51) Int Cl.:
*G06K 19/07* *(2006.01)*      *G01R 27/26* *(2006.01)*
*G01R 29/10* *(2006.01)*

(21) Anmeldenummer: **14000823.6**

(22) Anmeldetag: **07.03.2014**

(54) **Spuleninduktivität**

Coil inductance

Inductance de bobine

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.03.2013   DE 102013004227**

(43) Veröffentlichungstag der Anmeldung:
**17.09.2014   Patentblatt 2014/38**

(73) Patentinhaber: **Giesecke+Devrient Mobile Security GmbH**
**81677 München (DE)**

(72) Erfinder:
 • **Finkenzeller, Klaus**
 **85774 Unterföhring (DE)**
 • **Baldischweiler, Michael**
 **81825 München (DE)**
 • **Forster, Georg**
 **81825 München (DE)**

(56) Entgegenhaltungen:
DE-T5-112006 001 115      GB-A- 581 246
US-A1- 2012 264 373      US-B1- 6 236 220

 • **KLAUS FINKENZELLER: "RFID-Handbuch", 2012, CARL HANSER VERLAG, XP002765338, ISBN: 978-3-446-42992-5 Seiten 121-125, * Kapitel 4.1.11.2 ***

EP 2 779 030 B1

**Beschreibung**

Die vorliegende Erfindung betrifft ein Verfahren zum Bestimmen der Induktivität eines Schwingkreises, insbesondere die Induktivität einer Antennenspule eines zur kontaktlosen Datenkommunikation eingerichteten Schaltkreises, sowie eine entsprechend eingerichtete Prüfvorrichtung.

Bekannte Verfahren zum Bestimmen der Induktivität einer solchen Spule sind vergleichsweise kompliziert und benötigen teils einen aufwendigen Messaufbau.

Aus der GB 581 246 A ist es bekannt, die Induktivität eines Schwingkreises durch Einbringen einer zusätzlichen Impedanz in den Schwingkreis zu bestimmen. Anschließend wird die Induktivität auf Basis von Schwingkreisparametern des durch die Impedanz modifizierten Schwingkreises, durch Schwingkreisparameter des nicht modifizierten Schwingkreises und durch die eingebrachte Impedanz berechnet.

Aufgrund der notwendigen galvanischen Verbindung ist ein solches Verfahren aufwendig und nicht für Anordnungen geeignet, bei denen eine Messung in geringer Zeit durchgeführt werden muss.

Weiterer Stand der Technik ist aus der DE 11 2006 001 115 T5, der US 2012/0264373 A1 und der US 6,236,220 B1 bekannt.

Aufgabe der vorliegenden Erfindung ist es, ein Verfahren und eine Prüfvorrichtung vorzuschlagen, welche es erlauben, auf effiziente Weise, insbesondere schnell, einfach und kostengünstig, die Induktivität eines Schwingkreises, insbesondere umfassend eine Spule, zu bestimmen.

Diese Aufgabe wird durch ein Verfahren und eine Prüfvorrichtung mit den Merkmalen der unabhängigen Ansprüche gelöst. Vorteilhafte Ausgestaltungen und Weiterbildungen der Erfindung sind in den abhängigen Ansprüchen angegeben.

Ein erfindungsgemäßes Verfahren zum Bestimmen der Induktivität eines Schwingkreises, insbesondere einer Spule, umfasst die folgenden Schritte: Der Schwingkreis wird dadurch modifiziert, dass eine zusätzliche Impedanz in den Schwingkreis eingebracht wird. Danach wird ein vorgegebener Schwingkreisparameter des durch das Einbringen der Impedanz modifizierten Schwingkreises bestimmt. Der vorgegebene Schwingkreisparameter wird dabei derart gewählt, dass er in einer vorgegebenen Beziehung zu der Induktivität des ursprünglichen, nicht modifizierten Schwingkreises steht. Anschließend wird die Induktivität des ursprünglichen, nicht modifizierten Schwingkreises auf Basis des im vorhergehenden Verfahrensschritt bestimmten vorgegebenen Schwingkreisparameters des modifizierten Schwingkreises, des entsprechenden Schwingkreisparameters des ursprünglichen, nicht modifizierten Schwingkreises sowie der eingebrachten Impedanz bestimmt.

Ein solches Vorgehen ist insbesondere dann möglich, wenn die Beziehung, welche den Zusammenhang des vorgegebenen Schwingkreisparameters des modifizierten Schwingkreises zur Induktivität des nicht modifizierten Schwingkreises beschreibt, sowie die Beziehung, welche den Zusammenhang des vorgegebenen Schwingkreisparameters des nicht modifizierten Schwingkreises zur Induktivität des nicht modifizierten Schwingkreises beschreibt, neben der Induktivität des nicht modifizierten Schwingkreises lediglich eine weitere, gemeinsame Unbekannte umfassen, beispielsweise eine parasitäre Kapazität des nicht modifizierten Schwingkreises. Die weitere Abhängigkeit der Beziehung, welche den Zusammenhang des vorgegebenen Schwingkreisparameters des modifizierten Schwingkreises zur Induktivität des nicht modifizierten Schwingkreises beschreibt, von der zusätzlich eingebrachten Impedanz, deren Art und Betrag bekannt ist, erlaubt bei einer Kombination der beiden Beziehungen ein Auflösen nach der Induktivität des ursprünglichen, nicht modifizierten Schwingkreises.

Mit anderen Worten, es wird ein vorgegebener Schwingkreisparameter des modifizierten Schwingkreises bestimmt, welcher in einer vorgegebenen Beziehung zu der Induktivität des ursprünglichen, nicht modifizierten Schwingkreises steht. Diese Beziehung umfasst bekannte und unbekannte Parameter. Bekannte und unbekannte Parameter sind dabei im Sinne von bekannten und unbekannten Variablen einer mathematischen Gleichung zu verstehen. Ein bekannter Parameter dieser Beziehung ist die zusätzlich eingebrachte Impedanz. Der einzige unbekannte Parameter dieser Beziehung, neben der Induktivität des nicht modifizierten Schwingkreises, welche nicht bekannt und gerade zu bestimmen ist, ist ein weiterer Parameter des nicht modifizierten Schwingkreises. Dieser weitere unbekannte Parameter kann, wie erwähnt, beispielsweise eine parasitäre Kapazität des nicht modifizierten Schwingkreises sein.

Der dem vorgegebenen Schwingkreisparameter des modifizierten Schwingkreises entsprechende vorgegebene Schwingkreisparameter des ursprünglichen, nicht modifizierten Schwingkreises steht in einer vergleichbaren Beziehung zu der Induktivität des ursprünglichen, nicht modifizierten Schwingkreises. Auch diese Beziehung kann bekannte und unbekannte Parameter im obigen Sinne umfassen. Der einzige unbekannte Parameter, außer der Induktivität des nicht modifizierten Schwingkreises, ist dabei derselbe unbekannte Parameter, welchen auch die Beziehung des vorgegebenen Schwingkreisparameters des modifizierten Schwingkreises zu der Induktivität des ursprünglichen, nicht modifizierten Schwingkreises umfasst.

Zum Bestimmen der Induktivität des ursprünglichen, nicht modifizierten Schwingkreises wird nun die Beziehung des vorgegebenen Schwingkreisparameters des modifizierten Schwingkreises zu der Induktivität des ursprünglichen, nicht modifizierten Schwingkreises und die Beziehung des entsprechenden vorgegebenen Schwingkreisparameters des ursprünglichen, nicht modifizierten Schwingkreises zu der Induktivität des ursprünglichen, nicht modifizierten Schwingkreises kombiniert, um daraus die Induktivität der ursprünglichen, nicht modifizierten Schwingkreises abzuleiten. Diese Vorgehensweise entspricht im Wesentlichen dem Lösen eines Gleichungssystems mit zwei Gleichungen und zwei Unbekannten.

Sofern der dem vorgegebenen Schwingkreisparameter entsprechende Schwingkreisparameter des ursprünglichen, nicht modifizierten Schwingkreises zu Beginn des Verfahrens noch nicht bekannt ist, kann in einem weiteren Verfahrensschritt, vor dem Bestimmen der Induktivität, dieser Schwingkreisparameter, analog zum Bestimmen des vorgegebenen Schwingkreisparameters des modifizierten Schwingkreises, bestimmt werden. Das Bestimmen des Schwingkreisparameters des nicht modifizierten Schwingkreises kann dabei vor dem Einbringen der zusätzlichen Impedanz bestimmt werden. Alternativ ist es möglich, den vorgegebenen Schwingkreisparameter nach einem Entfernen der zusätzlich eingebrachten Impedanz zu bestimmen.

Als vorgegebene Schwingkreisparameter des modifizierten Schwingkreises und des nicht modifizierten, ursprünglichen Schwingkreises können insbesondere die Eigenresonanzfrequenz oder die Güte des jeweiligen Schwingkreises bestimmt werden. Diese Parameter hängen jeweils in vorgegebener Weise von der Induktivität des ursprünglichen, nicht modifizierten Schwingkreises ab. Ausgehend von solchen Schwingkreisparametern der modifizierten und des nicht modifizierten Schwingkreises lässt sich die Induktivität des nicht modifizierten Schwingkreises, in Kenntnis der eingebrachten Impedanz, auf einfache Weise berechnen. Konkrete Beispiele einer solchen Berechnung auf Basis der bestimmten Schwingkreisparameter werden nachfolgend im Detail beschrieben.

Der Schwingkreis wird nur temporär modifiziert. Insbesondere ist es vorteilhaft, dass die zusätzliche Impedanz in den Schwingkreis (temporär und) kontaktlos eingekoppelt werden kann.

Der Schwingkreis umfasst eine Spule, in der Regel eine Antennenspule, insbesondere mit mindestens einer Windung und (zwei) Schaltkreisanschlüssen. Der Schwingkreis kann einen angeschlossenen Schaltkreis umfassen. Die Spule ist (und der Schaltkreis ist) ausgebildet für eine kontaktlose Kommunikation, vorzugsweise mittels induktiver Kopplung. Die zusätzliche Impedanz wird erfindungsgemäß kontaktlos eingekoppelt, beispielsweise vorteilhaft über die Schaltkreisanschlüsse. Ebenso könnten aber auch andere Flächen der Spule, beispielsweise Kondensatorflächen, verwendet werden.

Das erfindungsgemäße Verfahren erlaubt es somit, die Induktivität eines gegebenen Schwingkreises effizient zu bestimmen. Es ist dazu im Wesentlichen ausreichend, den vorgegebenen Schwingkreisparameter des modifizierten Schwingkreises nach dem Einbringen der zusätzlichen Impedanz zu bestimmen. Falls noch nicht bekannt, muss noch der entsprechende Schwingkreisparameter des nicht modifizierten Schwingkreises auf analoge Weise bestimmt werden. Zum Bestimmen solcher vorgegebener Schwingkreisparameter, insbesondere der Eigenresonanzfrequenz oder der Güte einer Spule, sind effiziente Verfahren bekannt, welche ohne großen apparativen Aufwand in einfacher und kostengünstiger Weise durchgeführt werden können. Insbesondere können solche Verfahren kontaktlos, d.h. ohne die Notwendigkeit einer Kontaktierung der Spule, durchgeführt werden.

Erfindungsgemäß umfasst der Schritt des Bestimmens des vorgegebenen Schwingkreisparameters des modifizierten Schwingkreises folgende Teilschritte:
Der modifizierte Schwingkreis wird mittels eines Energiepulses angeregt. Eine Schwingung des modifizierten Schwingkreises in Antwort auf die Anregung wird erfasst. Schließlich wird die erfasste Schwingung des modifizierten Schwingkreises hinsichtlich des vorgegebenen Schwingkreisparameters ausgewertet.

Es versteht sich, dass auch der Schritt des Bestimmens des vorgegebenen Schwingkreisparameters der ursprünglichen, nicht modifizierten Spule, falls erforderlich, analog, d.h. mittels der Teilschritte des Anregens des ursprünglichen, nicht modifizierten Schwingkreises mittels eines Energiepulses, des Erfassens einer Schwingung des nicht modifizierten Schwingkreises in Antwort auf die Anregung, und des Auswertens einer erfassten Schwingung des ursprünglichen, nicht modifizierten Schwingkreises hinsichtlich des entsprechenden Schwingkreisparameters, ausgeführt werden kann.

Das Anregen einer Spule, d.h. des modifizierten Schwingkreises oder des nicht modifizierten Schwingkreises, erfolgt dabei vorzugsweise als induktives Anregen mittels eines gepulsten Magnetfeldes. Das Magnetfeld wird in der Regel durch einen einzelnen Strompuls erzeugt, beispielsweise durch einen Gleichstrompuls in Form eines Dirac-Stoßes.

Vorzugsweise erfolgt das Anregen eines Schwingkreises dabei kontaktlos mittels einer externen Erregerspule.

Das Erfassen einer Schwingung eines Schwingkreises erfolgt ebenfalls kontaktlos, vorzugsweise mittels einer externen Messantenne.

Ein durch einen Energiepuls angeregter Schwingkreis schwingt nach der Anregung grundsätzlich unmittelbar mit einer freien, gedämpften Schwingung A(t) aus, welche mit der folgenden Formel beschrieben werden kann:

$$A(t) = A_0\, e^{-\delta\, t}\, \cos(\omega\, t). \qquad (*)$$

A(t) kann dabei dem Strom I oder der Spannung U eines elektrischen Schwingkreises entsprechen, der insbesondere durch die Spule gebildet wird. Demnach kann der Spannungsverlauf des Schwingkreises unmittelbar nach der Anregung mit der folgenden Formel beschrieben werden:

$$U(t) = U_0\, e^{-\delta\, t}\, \cos(\omega\, t).$$

Die Kreisfrequenz $\omega$ entspricht dabei der Eigenresonanzfrequenz des Schwingkreises fres multipliziert mit $2\pi$ ($\omega = 2\,\pi f_{res}$). Aus dem Abklingkoeffizienten $\delta$ und der Eigenresonanzfrequenz $f_{res}$ kann die Güte Q des Schwingkreises ermittelt werden. Alternativ kann die Güte Q auch aus zwei aufeinander folgenden Maxima $A_n$ und $A_{n+1}$ der Schwingungsamplitude des Schwingkreises ermittelt werden.

$$Q = \frac{\pi \ast f_{res}}{\delta} = \frac{\pi}{\ln\left(\frac{A_n}{A_{n+1}}\right)}$$

Ist beispielsweise die Eigenresonanzfrequenz des modifizierten Schwingkreises und des ursprünglichen, nicht modifizierten Schwingkreises bekannt, so kann daraus in einfacher, nachstehend im Detail beschriebener Weise die Induktivität des nicht modifizierten Schwingkreises abgeleitet werden.

Eine erfindungsgemäße Prüfvorrichtung zum Bestimmen der Induktivität eines Schwingkreises umfasst die folgenden Komponenten:
Eine Impedanzmodifikationseinrichtung der Prüfvorrichtung ist eingerichtet, den Schwingkreis durch Einbringen einer zusätzlichen Impedanz in den Schwingkreis zu modifizieren.

Eine Schwingkreisparameterbestimmungseinrichtung ist eingerichtet, einen vorgegebenen Schwingkreisparameter des modifizierten Schwingkreises zu bestimmen.

Eine Induktivitätsbestimmungseinrichtung der Prüfvorrichtung ist eingerichtet, die Induktivität des ursprünglichen, nicht modifizierten Schwingkreises auf Basis des ermittelten Schwingkreisparameters des modifizierten Schwingkreises, des entsprechenden Schwingkreisparameters des ursprünglichen, nicht modifizierten Schwingkreises sowie der eingebrachten Impedanz zu bestimmen.

Es versteht sich, dass die Schwingkreisparameterbestimmungseinrichtung ebenfalls eingerichtet ist, den dem vorgegebenen Schwingkreisparameter entsprechenden Schwingkreisparameter des ursprünglichen, nicht modifizierten Schwingkreises zu bestimmen. Mit anderen Worten, die Schwingkreisparameterbestimmungseinrichtung ist eingerichtet, den Schwingkreisparameter unabhängig von der Modifikation des Schwingkreises durch die Impedanzmodifikationseinrichtung zu bestimmen.

Spezifische Schwingkreisparameter, welche mittels der Schwingkreisparameterbestimmungseinrichtung bestimmt werden können, sind, wie erwähnt, insbesondere die Eigenresonanzfrequenz und/oder die Güte eines Schwingkreises.

Erfindugsgemäß umfasst die Schwingkreisparameterbestimmungseinrichtung folgende Komponenten:
Ein Impulsgeber der Schwingkreisparameterbestimmungseinrichtung ist eingerichtet, einen in der Prüfvorrichtung anordenbaren Schwingkreis über eine an den Impulsgeber angeschlossene Erregerspule kontaktlos anzuregen. Eine Messantenne ist eingerichtet, eine Schwingung des Schwingkreises zu erfassen. Eine Auswertungsvorrichtung, die mit der Messantenne verbunden ist, ist eingerichtet, die von der Messantenne erfasste Schwingung hinsichtlich des vorgegebenen Schwingkreisparameters auszuwerten.

In der Regel sind die Erregerspule und die Messantenne orthogonal zueinander angeordnet. In dem Fall, dass die Erregerspule und die Messantenne nicht orthogonal zueinander, sondern beispielsweise nebeneinander angeordnet sind, wird der Erregungspuls der Erregerspule auch von der Messantenne erfasst. Zudem überlagert dann das Abschwingverhalten der Erregerspule das zu messende Abschwingverhalten der Antennenspule.

Bei einer "orthogonalen" Anordnung der Erregerspule zu der Messantenne liegen diese derart zueinander, dass das Signal der Erregerspule von der Messantenne nicht wahrgenommen wird. Die Erregerspule ist dabei gegenüber der Messantenne räumlich so angeordnet, dass in der Messantenne im Wesentlichen kein Signal eingekoppelt wird. Ein Signal wird in eine Spule immer dann eingekoppelt, wenn das Ringintegral über den magnetischen Fluss $\Phi$ durch diese Spule größer als Null ist (vgl. "RFID-Handbuch" von Klaus Finkenzeller, 5. Auflage, Carl Hanser Verlag, München, 2012, Kapitel 4.1.6 und 4.1.9.2). Das Integral über den magnetischen Fluss $\Phi$ ist genau dann Null, wenn sich magnetische Feldlinien unterschiedlicher Richtung und Feldstärke in der Messantenne über die Gesamtfläche gegenseitig aufheben, oder wenn der Winkel der Feldlinien zur Spulenachse genau 90° beträgt - daher der Begriff "orthogonale" Anordnung. Eine geeignete, so genannte koplanare orthogonale Anordnung der Erregerspule zur Messantenne kann beispielsweise derart erfolgen, dass die beiden Antennen in einer Ebene geeignet teilweise übereinander liegen.

Grundsätzlich kann als zusätzliche Impedanz ein ohmscher Widerstand, eine zusätzliche Induktivität oder eine Kapazität in den ursprünglichen Schwingkreis eingebracht werden. Die Impedanzmodifikationseinrichtung der Prüfvorrichtung ist entsprechend eingerichtet.

Gemäß einer bevorzugten Ausführungsform des erfindungsgemäßen Verfahrens wird als zusätzliche Impedanz eine Kapazität in den ursprünglichen, nicht modifizierten Schwingkreiseingebracht. Die Kapazität kann dabei in Form eines diskreten Bauteils, beispielsweise in Form eines Kondensators, in den ursprünglichen Schwingkreis eingebracht werden.

Alternativ kann die Kapazität dadurch in den ursprünglichen, nicht modifizierten Schwingkreiseingebracht werden, dass eine Elektrode in vorgegebener Weise an den ursprünglichen, nicht modifizierten Schwingkreisangenähert wird. Die Elektrode wirkt dabei zusammen mit einem vorgegebenen Teil des ursprünglichen, nicht modifizierten Schwingkreises als ein Kondensator, wobei dieser Teil des Schwingkreises ebenfalls als eine Elektrode dient.

Als Elektrode kann beispielsweise eine Metallplatte verwendet werden. Vorzugsweise wird die Elektrode mittels eines Dielektrikums von dem ursprünglichen, nicht modifizierten Schwingkreis in vorgegebener Weise beabstandet.

Der ursprüngliche Schwingkreis kann beispielsweise auf einer Trägerschicht aufgebracht sein. Zumindest ein Anschlusskontakt des nicht modifizierten Schwingkreises auf der Trägerschicht kann in der beschriebenen Weise als die zweite Elektrode dienen, d.h. zusammen mit der angenäherten Elektrode als Kondensator vorgegebener Kapazität wirken.

In dem Fall, dass als zusätzliche Impedanz eine Kapazität in den ursprünglichen, nicht modifizierten Schwingkreiseingebracht wird, kann der Schritt des Bestimmens der Induktivität des nicht modifizierten Schwingkreises beispielsweise wie folgt durchgeführt werden:

Die Induktivität des ursprünglichen, nicht modifizierten Schwingkreises wird bestimmt aus der Beziehung:

$$L = \frac{1}{C_x}\left[\left(\frac{1}{2\pi f_x}\right)^2 - \left(\frac{1}{2\pi f_0}\right)^2\right], \qquad (1)$$

wobei L die Induktivität des ursprünglichen, nicht modifizierten Schwingkreises bezeichnet. Mit $f_0$ wird die Eigenresonanzfrequenz des nicht modifizierten Schwingkreises bezeichnet, mit $f_x$ die Eigenresonanzfrequenz des modifizierten Schwingkreises und mit $C_x$ die eingebrachte Kapazität.

Die Beziehung (1) ergibt sich dabei in einfacher Weise aus der Beziehung

$$f_0 = \frac{1}{2\pi\sqrt{L\,C_p}} \qquad (2)$$

und der Beziehung

$$f_x = \frac{1}{2\pi\sqrt{L\,(C_p + C_x)}} \qquad (3).$$

Die Beziehung (2) gibt an, in welcher Weise die Eigenresonanzfrequenz des ursprünglichen, nicht modifizierten Schwingkreises von der Induktivität des ursprünglichen, nicht modifizierten Schwingkreises und einer parasitären Kapazität des nicht modifizierten Schwingkreises abhängt. Die parasitäre Kapazität wird dabei mit $C_p$ bezeichnet.

Beziehung (3) gibt in entsprechender Weise an, in welche Weise die Eigenresonanzfrequenz des modifizierten Schwingkreises von der Induktivität des nicht modifizierten Schwingkreises und einer Summe aus der parasitären Kapazität des nicht modifizierten Schwingkreises und der in den ursprünglichen Schwingkreis eingebrachten zusätzlichen Kapazität abhängt.

Um Beziehung (1) zu erhalten, muss lediglich beispielsweise Beziehung (2) nach $C_p$ aufgelöst und in Beziehung (3) eingesetzt werden, welche dann nach L aufgelöst wird. Dies ist möglich, da der Betrag der eingebrachten Kapazität $C_x$ bekannt ist.

Auf analoge Weise kann vorgegangen werden, wenn beispielsweise anstelle der Eigenresonanzfrequenz als vorgegebener Schwingkreisparameter die Güte der Spulen bestimmt wird. Ausgehend von entsprechenden Beziehungen, welche die Güte eines Schwingkreises in Abhängigkeit von der Induktivität des nicht modifizierten Schwingkreises, einer entsprechenden Kapazität des Schwingkreises sowie beispielsweise eines erfassten Dämpfungsparameters $\delta$

darstellen, kann auf die Induktivität des nicht modifizierten Schwingkreises zurückgeschlossen werden (wegen des Parameters $\delta$, vgl. die Beziehung (*), welche grundsätzlich den Verlauf einer freien, gedämpften Schwingung definiert). Auf eine abermalige explizite Darstellung der Berechnung der Induktivität in diesem speziellen Fall wird hier verzichtet.

Wie erwähnt, ist die Prüfvorrichtung gemäß einer bevorzugten Ausführungsform mit einer Impedanzmodifikationseinrichtung ausgestattet, die eingerichtet ist, als zusätzliche Impedanz eine Kapazität in den ursprünglichen, nicht modifizierten Schwingkreiseinzubringen. Die Impedanzmodifikationseinrichtung kann eingerichtet sein, die Kapazität in Form eines diskreten Bauteils, beispielsweise in Form eines Kondensators, in den ursprünglichen Schwingkreis einzubringen.

Alternativ kann die Impedanzmodifikationseinrichtung eingerichtet sein, die Kapazität dadurch in den ursprünglichen, nicht modifizierten Schwingkreiseinzubringen, dass eine Elektrode, beispielsweise eine Metallplatte, in vorgegebener Weise an den ursprünglichen, nicht modifizierten Schwingkreisangenähert wird. In der Regel ist die Elektrode mittels eines Dielektrikums versehen.

Die vorliegende Erfindung wird im Folgenden mit Bezug auf die beiliegenden Zeichnungen exemplarisch beschrieben. Darin zeigen:

Figur 1    eine bevorzugte Ausführungsform einer erfindungsgemäßen Prüfvorrichtung beim Bestimmen einer Induktivität einer auf einem Träger angeordneten Antennenspule;

Figur 2    ein Ersatzschaltbild der Antennenspule aus Fig. 1;

Figur 3    den Träger mit Antennenspule und zusätzlich eingebrachter Kapazität aus Fig. 1 in einer seitlichen Schnittansicht;

Figur 4    Schritte einer bevorzugten Ausführungsform eines erfindungsgemäßen Verfahrens;

Figur 5    Teilschritte einer bevorzugten Variante des Schritts S2 des Verfahrens aus Fig. 4; und

Figur 6    schematisch eine freie, gedämpfte Schwingung.

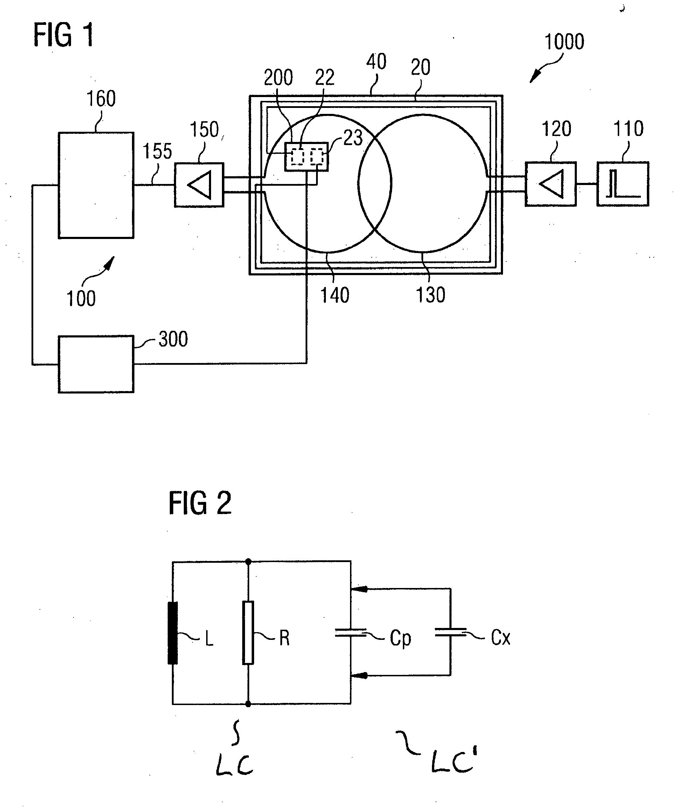

In Fig. 1 ist eine Prüfvorrichtung 1000 zum Bestimmen einer Induktivität einer Spule 20 gezeigt.

Die (nicht modifizierte) Spule 20 ist dabei auf einem flächigen Träger 40 angeordnet. Die Spule 20 umfasst mindestens eine Windung und zwei Anschlusskontakte 22, 23. Der Träger 40 kann als Inlayfolie ausgebildet sein, welche als Zwischenschicht eines mehrlagigen, kartenförmigen Datenträgers dienen kann. Dabei kann die Antennenspule 20 als Antenne dienen, mittels welcher ein entsprechender Datenträger eine kontaktlose Datenkommunikation mit einem geeigneten Lesegerät durchführen kann. Über die Anschlusskontakte 22, 23 kann die Antenne 20 beispielsweise mit einem elektronischen Schaltkreis eines solchen Datenträgers kontaktiert (sein oder) werden.

Die Prüfvorrichtung 1000 umfasst eine Spulenparameterbestimmungseinrichtung 100, eine Impedanzmodifikationseinrichtung 200 sowie eine Induktionsbestimmungseinrichtung 300.

Die Impedanzmodifikationseinrichtung 200 ist eingerichtet, eine zusätzliche Impedanz in eine in der Prüfvorrichtung angeordnete Spule 20 einzubringen.

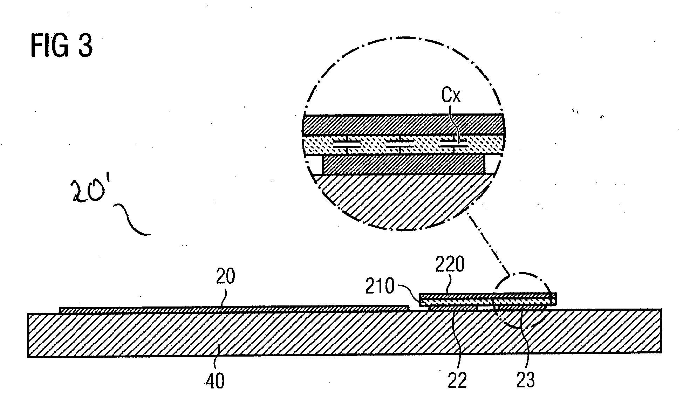

In dem gezeigten Beispiel erfolgt dies als Einbringen einer zusätzlichen Kapazität $C_x$ (vgl. Fig. 2). Mittels der Impedanzmodifikationseinrichtung wird eine Metallplatte 220 (vgl. Fig. 3), welche einseitig eine Dielektrikumsschicht 210 umfasst, derart im Bereich der Anschlusskontakte 22, 23 an die Spule 20 auf dem Träger 40 angenähert, dass sich dadurch eine Kapazität $C_x$ ergibt. Fig. 3 zeigt entsprechend einen modifizierten Schwingkreis 20'.

Tatsächlich entspricht eine derartige Anordnung der Metallplatte 220, 210 einer Reihenschaltung von zwei Kondensatoren $C_1$ und $C_2$, wobei der Kondensator $C_1$ vom Anschlusskontakt 22 mit der Metallplatte 220 gebildet wird und der Kondensator $C_2$ vom Anschlusskontakt 23 mit der Metallplatte 220. Theoretisch kann die Metallplatte 220 auch auf der Unterseite des Trägers 40 angeordnet werden, insbesondere wenn beispielsweise bereits ein Schaltkreis auf den Anschlussflächen 22,23 angeordnet ist oder eine andere Fläche der Spule 20 verwendet wird.

Der Betrag der zusätzlichen Kapazität $C_x$ ist dabei genau bestimmbar und beträgt mit Bezug auf das beschriebene Beispiel 0,7 *pF*.

Wie in Fig. 2 angedeutet, kann die Spule 20 im Zusammenhang der vorliegenden Erfindung als Parallelschwingkreis LC mit einer Induktivität $L$, einem ohmschen Widerstand $R$ sowie einer parasitären Kapazität $C_p$ angesehen werden. Eine mittels der Impedanzmodifikationseinrichtung 200 zusätzlich eingebrachte Kapazität ist, wie bereits erwähnt, mit $C_x$ bezeichnet. Aus dem nicht modifizierten Schwingkreis LC wird durch Einbringen der Kapazität $C_x$ der modifizierte Schwingkreis LC'.

Die Spulenparameterbestimmungseinrichtung 100 ist eingerichtet, einen vorgegebenen Spulenparameter einer in der Prüfvorrichtung 1000 angeordneten Spule 20 zu bestimmen. Dies gilt für eine ursprüngliche, d.h. nicht modifizierte Spule 20 wie für eine mittels der Impedanzmodifikationseinrichtung 200 modifizierte Spule 20'.

Bevorzugte Spulenparameter sind beispielsweise eine Eigenresonanzfrequenz oder eine Güte der Spule 20.

Die in Fig. 1 gezeigte Ausführungsform der Spulenparameterbestimmungseinrichtung 100 umfasst einen Impulsgeber 110, der vorzugsweise über einen Verstärker 120 mit einer Erregerspule 130 verbunden ist. Mittels eines durch den Impulsgeber 110 erzeugten Energiepulses, vorzugsweise in Form eines Dirac-Stoßes, kann eine Spule 20 über die Erregerspule 130 kontaktlos angeregt werden.

Eine Messantenne 140 der Spulenparameterbestimmungseinrichtung 100 ist eingerichtet, eine Schwingung der Spule 20 zu erfassen und vorzugsweise über einen Verstärker 150 an eine Auswertungseinrichtung 160 weiterzuleiten. Die Auswertungseinrichtung 160 kann beispielsweise als Oszilloskop vorliegen.

Erregerspule 130 und Messantenne 140 werden in geeignetem, vorzugsweise geringem Abstand neben der Spule 20 angeordnet, ohne die Spule 20 kontaktbehaftet zu kontaktieren.

Wie im Fig. 1 durch die teilweise überlappende Anordnung angedeutet, sind die Messantenne 140 und Erregerspule 130 dabei orthogonal zueinander angeordnet. Dies hat, wie vorstehend beschrieben, die Auswirkungen, dass in die Messantenne 140 möglichst kein Signal der Erregerspule 130 eingekoppelt wird. Die Erregerspule 130 und die Messantenne 140 können auf einem geeigneten, flächigen Träger angeordnet werden.

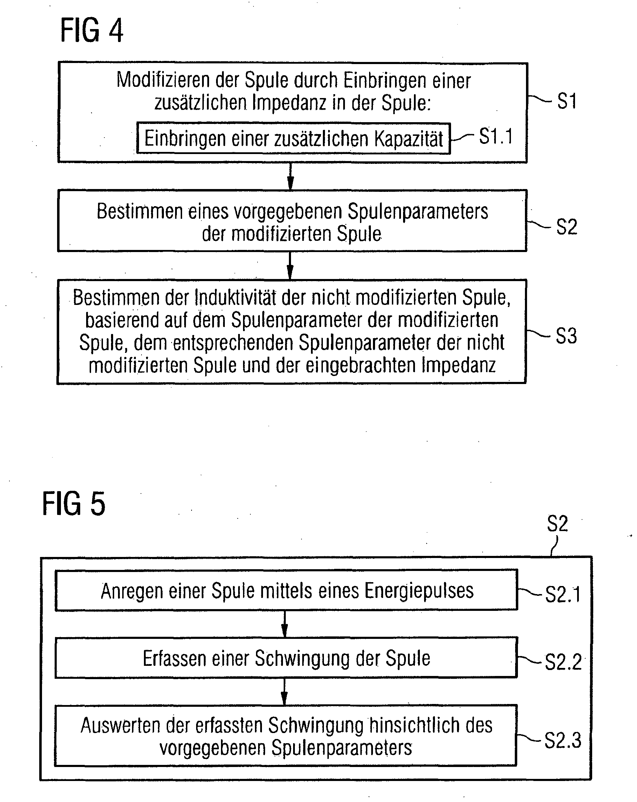

Wie nachfolgend mit Bezug auf die Fig. 4 bis 6 beschrieben, eignet sich eine derartige Spulenparameterbestimmungseinrichtung 100 in besonderer Weise, einen vorgegebenen Spulenparameter, insbesondere eine Eigenresonanzfrequenz oder eine Güte einer Spule, einfach, schnell und kostengünstig zu bestimmen. Mit anderen Worten, unter Verwendung einer solchen Spulenparameterbestimmungseinrichtung 100 kann auch die Induktivität einer Spule effektiv, mit wenigen Zusatzschritten und wie nachfolgend beschrieben, bestimmt werden.

Die Induktionsbestimmungseinrichtung 300 ist eingerichtet, auf Basis des vorgegebenen Spulenparameters des modifizierten Schwingkreises, des entsprechenden Spulenparameters des nicht modifizierten Schwingkreises sowie der Art und des Betrags der zusätzlich eingebrachten Impedanz eine Induktivität des nicht modifizierten Schwingkreises zu bestimmen.

Eine solche Bestimmung der Induktivität stützt sich dabei auf bekannte Beziehungen, welche jeweils den Spulenparameter des nicht modifizierten Schwingkreises und den Spulenparameter des modifizierten Schwingkreises in Abhängigkeit von der Induktivität der ursprüngliche Spule und, mit Bezug auf die modifizierte Spule, in zusätzlicher Abhängigkeit von der - bekannten - zusätzlich eingebrachten Impedanz beschreiben. Aufgrund der Tatsache, dass die verwendeten Beziehungen außer der Induktivität des nicht modifizierten Schwingkreises nur noch eine weitere Unbekannte, beispielsweise die parasitäre Kapazität des nicht modifizierten Schwingkreises, umfassen, kann eine Kombination der verwendeten Beziehungen nach der Induktivität aufgelöst werden. Ein konkretes Rechenbespiel folgt mit Bezug auf die Fig. 4 und 5.

In Fig. 4 sind Schritte eines Verfahrens zum Bestimmen einer Induktivität einer Spule angegeben.

In einem ersten Schritt S1 wird eine zusätzliche Impedanz in die Spule eingebracht. Im gezeigten Beispiel erfolgt dies dadurch, wie in Teilschritt S1.1 angedeutet, dass eine zusätzliche Kapazität in die Spule eingebracht wird.

In Schritt S2 wird ein vorgegebener Spulenparameter der durch das Einbringen der zusätzlichen Kapazität modifizierten Spule bestimmt, beispielsweise eine Eigenresonanzfrequenz $f_x$ des modifizierten Schwingkreises.

Die Eigenresonanzfrequenz des modifizierten Schwingkreises steht dabei in einer bekannten Beziehung zu der zu bestimmenden Induktivität $L$ des nicht modifizierten Schwingkreises, der parasitären Kapazität $C_p$ des nicht modifizierten Schwingkreises und der zusätzlich eingebrachten Kapazität $C_x$. Es gilt die Beziehung

$$f_x = \frac{1}{2\,\pi\sqrt{L\,(C_p + C_x)}}.$$

In analoger Weise verhält sich die Eigenresonanzfrequenz $f_0$ der ursprünglichen, nicht modifizierten Spule zu ihrer Induktivität $L$ und der parasitären Kapazität $C_p$ vermöge $f_0 = \frac{1}{2\,\pi\sqrt{L\,C_p}}$.

In Schritt S3 wird die Induktivität des nicht modifizierten Schwingkreises auf Basis des in Schritt S2 bestimmten Spulenparameters $f_x$ des modifizierten Schwingkreises, des entsprechenden Parameters $f_0$ des nicht modifizierten Schwingkreises sowie der zusätzlich eingebrachten Impedanz $C_x$ bestimmt.

Konkret kann die Induktivität $L$ des nicht modifizierten Schwingkreises dadurch bestimmt werden, dass die Beziehung $f_0 = \frac{1}{2\,\pi\sqrt{L\,C_p}}$ nach $C_p$ aufgelöst wird: $C_p = \frac{1}{(2\pi f_0)^2\,L}$. Wird die rechte Seite in die Beziehung

$$f_x = \frac{1}{2\pi\sqrt{L\left(C_p + C_x\right)}}$$ eingesetzt und nach L aufgelöst, so ergibt sich:

$$L = \frac{1}{C_x}\left[\left(\frac{1}{2\pi\, f_x}\right)^2 - \left(\frac{1}{2\pi\, f_0}\right)^2\right].$$

In der in Fig. 4 gezeigten Ausführungsform wird davon ausgegangen, dass $f_o$ für die ursprüngliche Spule bereits bekannt ist. Falls nicht, kann der entsprechende Spulenparameter, d.h. die Eigenresonanzfrequenz der ursprünglichen, nicht modifizierten Spule, analog zu Schritt S2, in einem zusätzlichen Verfahrensschritt bestimmt werden, beispielsweise vor dem Einbringen der zusätzlichen Kapazität.

Der Schritt S1 des Einbringens einer zusätzlichen Impedanz kann parallel für mehrere Schwingkreise erfolgen. Die Vorrichtung umfasst entsprechend mehrere zusätzliche Impedanzen, die vorzugsweise durch einen gemeinsamen dielektrischen Träger 210 und mehrere metallische Flächen 220 gebildet werden. Beispielsweise kann unter einem Träger (Bogen) mit einer Mehrzahl von zu vermessenden Schwingkreisen ein gleichartiger dielektrischer Träger (zweiter Bogen) mit der gleichen Mehrzahl von Metallflächen angeordnet werden.

In Fig. 5 sind Teilschritte einer bevorzugten Variante des Schritts S2 aus Fig. 4, dem Schritt des Bestimmens eines vorgegebenen Spulenparameters, angegeben. Wie bereits erwähnt, kann Schritt S2 auch zum Bestimmen des vorgegebenen Spulenparameters der ursprünglichen, nicht modifizierten Spule herangezogen werden. Daher wird in Fig. 5 lediglich eine "Spule" erwähnt, ohne zu spezifizieren, ob die modifizierte oder die ursprüngliche, nicht modifizierte Spule gemeint ist.

In Teilschritt S2.1 wird die Spule 20 mittels eines Energiepulses angeregt. Dies kann mittels der Erregerspule 130 aus Fig. 1 durch Zusammenwirken mit dem Impulsgeber 110 erfolgen. Das Anregen erfolgt vorzugsweise mittels eines gepulsten Magnetfeldes induktiv, wobei das Magnetfeld vorzugsweise durch einen einzelnen Strompuls in Form eines Dirac-Stoßes erzeugt wird.

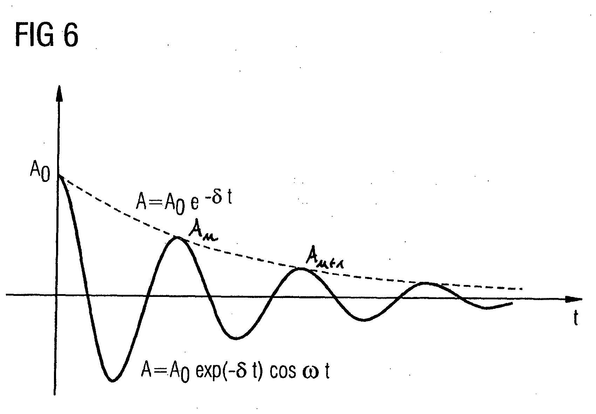

In Teilschritt S2.2 wird eine Schwingung der Spule 20 in Antwort auf das Anregen der Spule erfasst. Dazu dient die Messantenne 140 aus Figur 1. Eine erfasste Schwingung entspricht dabei einer freien, gedämpften Schwingung der Spule 20 (vgl. Fig. 6).

In Teilschritt S2.3 wird die erfasste Schwingung durch eine Auswertungseinrichtung, beispielsweise die Auswertungseinrichtung 160 aus Fig. 1, hinsichtlich des vorgegebenen Spulenparameters ausgewertet. Wie vorstehend beschrieben, kann in dieser Weise insbesondere eine Eigenresonanzfrequenz und/oder eine Güte der Spule auf einfach Weise ermittelt werden.

Figur 6 zeigt den theoretischen Verlauf einer freien, gedämpften Schwingung A(t) im Verlauf der Zeit t. Die Funktion A(t) kann dabei dem Strom I oder der Spannung U entsprechen. Die Kreisfrequenz $\omega$ entspricht der Eigenresonanzfrequenz der Spule 20. Aus dem Abklingkoeffizienten $\delta$ kann die Güte der Spule 20 bestimmt werden.

**Patentansprüche**

1. Verfahren zum Bestimmen einer Induktivität (L) eines Schwingkreises (LC), umfassend die Schritte:

- Modifizieren des Schwingkreises (LC; 20) durch Einbringen (S1) einer zusätzlichen Impedanz ($C_x$) in den Schwingkreis (LC; 20);
- Bestimmen (S2) eines vorgegebenen Schwingkreisparameters ($f_x$) des durch das Einbringen der Impedanz modifizierten Schwingkreises (LC'; 20'), wobei der Schwingkreisparameter ($f_x$) des modifizierten Schwingkreises (LC'; 20') in vorgegebener Beziehung zu der Induktivität (L) des nicht modifizierten Schwingkreises (LC; 20) steht;
- Bestimmen (S3) der Induktivität (L) des nicht modifizierten Schwingkreises (LC; 20) auf Basis des vorgegebenen Schwingkreisparameters ($f_x$) des modifizierten Schwingkreises (LC'; 20'), des vorgegebenen Schwingkreisparameters ($f_\emptyset$) des nicht modifizierten Schwingkreises (LC; 20) sowie der eingebrachten Impedanz ($C_x$) ;

**dadurch gekennzeichnet, dass**
die zusätzliche Impedanz ($C_x$) beim Einbringen (S1.1) kontaktlos in den Schwingkreis (LC; 20) eingekoppelt wird und der Schritt des Bestimmens (S2) des vorgegebenen Schwingkreisparameters ($f_x$) eine kontaktlose Messung umfasst, und
der Schritt des Bestimmens (S2) des vorgegebenen Schwingkreisparameters ($f_x$) des modifizierten Schwingkreises (LC'; 20') folgende Teilschritte umfasst:

- Anregen (S2.1) des modifizierten Schwingkreises (LC'; 20') mittels eines Energiepulses;
- Erfassen (S2.2) einer Schwingung des modifizierten Schwingkreises (LC'; 20') in Antwort auf die Anregung (S2.1);
- Auswerten (S2.3) einer erfassten Schwingung des modifizierten Schwingkreises (LC'; 20') hinsichtlich des vorgegebenen Schwingkreisparameters ($f_x$).

2. Verfahren nach Anspruch 1, **gekennzeichnet durch** den Schritt des Bestimmens des vorgegebenen Schwingkreisparameters ($f_\emptyset$) des nicht modifizierten Schwingkreises (20), wobei der Schwingkreisparameter in vorgegebener Beziehung zu der Induktivität (L) des nicht modifizierten Schwingkreises (20) steht.

3. Verfahren nach Anspruch 1 oder 2, **dadurch gekennzeichnet, dass** als vorgegebener Schwingkreisparameter ($f_x$) des modifizierten Schwingkreises (20') eine Eigenresonanzfrequenz ($f_x$) des modifizierten Schwingkreises (20') bestimmt wird und dass als entsprechender Schwingkreisparameter ($f_\emptyset$) des nicht modifizierten Schwingkreises (20) zum Bestimmen der Induktivität (L) eine Eigenresonanzfrequenz ($f_\emptyset$) des nicht modifizierten Schwingkreises (20) herangezogen wird.

4. Verfahren nach einem der Ansprüche 1 bis 3, **dadurch gekennzeichnet, dass** im Schritt des Modifizierens des Schwingkreises (20) als die zusätzliche Impedanz eine Kapazität ($C_x$) in den nicht modifizierten Schwingkreis (20) eingebracht wird.

5. Verfahren nach Anspruch 4, **dadurch gekennzeichnet, dass** die Kapazität ($C_x$) in Form eines diskreten Bauteils in den nicht modifizierten Schwingkreis (20) eingebracht wird.

6. Verfahren nach Anspruch 4, **dadurch gekennzeichnet, dass** die Kapazität ($C_x$) dadurch in die nicht modifizierte Schwingkreis (20) eingebracht wird, dass eine Elektrode (220) in vorgegebener Weise an den nicht modifizierten Schwingkreis (20) angenähert wird, wobei die Elektrode (220) zusammen mit einem vorgegebenen Teil (22; 23) des nicht modifizierten Schwingkreises (20) als Kondensator wirkt.

7. Verfahren nach einem der Ansprüche 4 bis 6, **dadurch gekennzeichnet, dass** die Induktivität (L) der nicht modifizierten Schwingkreis (20) bestimmt wird vermöge der Beziehung:

$$L = \frac{1}{C_x}\left[\left(\frac{1}{2\pi f_x}\right)^2 - \left(\frac{1}{2\pi f_\emptyset}\right)^2\right],$$

wobei $L$ die Induktivität des nicht modifizierten Schwingkreises, $f_o$ die Eigenresonanzfrequenz des nicht modifizierten Schwingkreises, $f_x$ die Eigenresonanzfrequenz des modifizierten Schwingkreises und $C_x$ die eingebrachte Kapazität bezeichnen.

8. Prüfvorrichtung (1000) zum Bestimmen der Induktivität (L) eines Schwingkreises (20) und zum Durchführen eines Verfahrens nach einem der vorhergehenden Ansprüche, wobei die Prüfvorrichtung (1000) umfasst:

- eine Impedanzmodifikationseinrichtung (200), welche eingerichtet ist, den Schwingkreis (20) durch Einbringen einer zusätzlichen Impedanz ($C_x$) zu modifizieren;
- eine Schwingkreisparameterbestimmungseinrichtung (100), welche eingerichtet ist, einen vorgegebenen Schwingkreisparameter ($f_x$) des modifizierten Schwingkreises (20) zu bestimmen;
- eine Induktivitätsbestimmungseinrichtung (300), welche eingerichtet ist, die Induktivität (L) des nicht modifizierten Schwingkreises (20) auf Basis des ermittelten Schwingkreisparameters ($f_x$) des modifizierten Schwingkreises (20), des entsprechenden Schwingkreisparameters ($f_\emptyset$) des nicht modifizierten Schwingkreises (20) sowie der eingebrachten Impedanz ($C_x$) zu bestimmen,

**dadurch gekennzeichnet,**
**dass** die zusätzliche Impedanz ($C_x$) kontaktlos in den Schwingkreis (20) eingekoppelt wird,
**dass** die Schwingkreisparameterbestimmungseinrichtung (100) eingerichtet ist, den vorgegebenen Schwingkreisparameter ($f_x$) des modifizierten Schwingkreise (LC'; 20') durch kontaktlose Messung zu bestimmen,
**dass** die Schwingkreisparameterbestimmungseinrichtung (100) die folgenden Mittel umfasst.

- Mittel zum Anregen (S2.1) des modifizierten Schwingkreises (LC'; 20') mittels eines Energiepulses;
- Mittel zum Erfassen (S2.2) einer Schwingung des modifizierten Schwingkreises (LC'; 20') in Antwort auf die Anregung (S2.1),
- Mittel zum Auswerten (S2.3) einer erfassten Schwingung des modifizierten Schwingkreises (LC'; 20') hinsichtlich des vorgegebenen Schwingkreisparameters ($f_x$).

9. Prüfvorrichtung (1000) nach Anspruch 8, **dadurch gekennzeichnet, dass** die Impedanzmodifikationseinrichtung (200) eingerichtet ist, als zusätzliche Impedanz ($C_x$) eine Kapazität in den Schwingkreis (20) einzubringen.

10. Prüfvorrichtung (1000) nach Anspruch 9, **dadurch gekennzeichnet, dass** die Impedanzmodifikationseinrichtung (200) eingerichtet ist, die Kapazität ($C_x$) in Form eines diskreten Bauteils in den Schwingkreis (20) einzubringen.

11. Prüfvorrichtung (1000) nach Anspruch 9 oder 10, **dadurch gekennzeichnet, dass** die Impedanzmodifikationseinrichtung (200) eingerichtet ist, die Kapazität ($C_x$) dadurch in den Schwingkreis (20) einzubringen, dass eine Elektrode (220) in vorgegebener Weise an den (20) Schwingkreis angenähert wird.

12. Prüfvorrichtung (1000) nach einem der Ansprüche 8 bis 11, **dadurch gekennzeichnet, dass** die Schwingkreisparameterbestimmungseinrichtung (100) eingerichtet ist, als den vorgegebenen Schwingkreisparameter ($f_0$; $f_x$) eines Schwingkreises (20) die Eigenresonanzfrequenz des Schwingkreises zu bestimmen.

13. Prüfvorrichtung (1000) nach einem der Ansprüche 8 bis 12, **dadurch gekennzeichnet, dass** die Schwingkreisparameterbestimmungseinrichtung (100) umfasst:

- einen Impulsgeber (110), der eingerichtet ist, einen in der Prüfvorrichtung (1000) anordenbaren Schwingkreis (20) über eine an den Impulsgeber (110) angeschlossene Erregerspule (130) kontaktlos anzuregen;
- eine Messantenne (140), die eingerichtet ist, eine Schwingung des Schwingkreises (20) zu erfassen; und
- eine Auswertungsvorrichtung (160), welche mit der Messantenne (140) verbunden ist und eingerichtet ist, die von der Messantenne (140) erfasste Schwingung hinsichtlich des vorgegebenen Schwingkreisparameters *(fx)* auszuwerten.

**Claims**

1. A method for determining an inductance (L) of an oscillating circuit (LC), comprising the steps of:

- modifying the oscillating circuit (LC; 20) by introducing (S1) an additional impedance ($C_x$) into the oscillating circuit (LC; 20);
- determining (S2) a predetermined oscillating circuit parameter ($f_x$) of the oscillating circuit (LC'; 20') modified by introducing the impedance, wherein the oscillating circuit parameter ($f_x$) of the modified oscillating circuit (LC'; 20') is in a predetermined relationship to the inductance (L) of the non-modified oscillating circuit (LC; 20),
- determining (S3) the inductance (L) of the non-modified oscillating circuit (LC; 20) on the basis of the predetermined oscillating circuit parameter ($f_x$) of the modified oscillating circuit (LC'; 20'), the predetermined oscillating circuit parameter ($f_∅$) of the non-modified oscillating circuit (LC; 20) and the introduced impedance ($C_x$);

**characterized in that**
the additional impedance ($C_x$) during introduction (S1.1) is coupled into the oscillating circuit (LC; 20) in contactless manner and the step of determining (S2) the predetermined oscillating circuit parameter ($f_x$) comprises a contactless measurement; and
the step of determining (S2) the predetermined oscillating circuit parameter ($f_x$) of the modified oscillating circuit (LC'; 20') comprises the following partial steps of:

- exciting (S2.1) the modified oscillating circuit (LC'; 20') by means of an energy pulse;
- detecting (S2.2) an oscillation of the modified oscillating circuit (LC'; 20') in response to the excitation (S2.1);
- evaluating (S2.3) a detected oscillation of the modified oscillating circuit (LC'; 20') with respect to the predetermined oscillating circuit parameter ($f_x$).

2. The method according to claim 1, **characterized by** the step of determining the predetermined oscillating circuit parameter ($f_∅$) of the non-modified oscillating circuit (20), wherein the oscillating circuit parameter is in a predetermined relationship to the inductance (L) of the non-modified oscillating circuit (20).

3. The method according to claim 1 or 2, **characterized in that** a self-resonant frequency ($f_x$) of the modified oscillating circuit (20') is determined as the predetermined oscillating circuit parameter ($f_x$) of the modified oscillating circuit (20') and that a self-resonant frequency ($f_\emptyset$) of the non-modified oscillating circuit (20) is consulted as the corresponding oscillating circuit parameter ($f_\emptyset$) of the non-modified oscillating circuit (20) for determining the inductance (L).

4. The method according to any of claims 1 to 3, **characterized in that** in the step of modifying the oscillating circuit (20), a capacitance ($C_x$) is introduced into the non-modified oscillating circuit (20) as the additional impedance.

5. The method according to claim 4, **characterized in that** the capacitance ($C_x$) is introduced in the form of a discrete component into the non-modified oscillating circuit (20).

6. The method according to claim 4, **characterized in that** the capacitance ($C_x$) is introduced into the non-modified oscillating circuit (20) **in that** an electrode (220) is approximated in a predetermined manner to the non-modified oscillating circuit (20), wherein the electrode (220), together with a predetermined part (22; 23) of the non-modified oscillating circuit (20), acts as a capacitor.

7. The method according to any of claims 4 to 6, **characterized in that** the inductance (L) of the non-modified oscillating circuit (20) is determined by the relationship:

$$L = \frac{1}{C_x}\left[\left(\frac{1}{2\pi f_x}\right)^2 - \left(\frac{1}{2\pi f_\emptyset}\right)^2\right].$$

where L denotes the inductance of the non-modified oscillating circuit, $f_\emptyset$ denotes the self-resonant frequency of the non-modified oscillating circuit, $f_x$ denotes the self-resonant frequency of the modified oscillating circuit and $C_x$ denotes the introduced capacitance.

8. A checking apparatus (1000) for determining the inductance (L) of an oscillating circuit (20) and for carrying out a method according to any of the preceding claims, wherein the checking apparatus (1000) comprises:

- an impedance modifying device (200) which is adapted to modify the oscillating circuit (20) by introducing an additional impedance ($C_x$);
- an oscillating circuit parameter determining device (100) which is adapted to determine a predetermined oscillating circuit parameter ($f_x$) of the modified oscillating circuit (20);
- an inductance determining device (300) which is adapted to determine the inductance (L) of the non-modified oscillating circuit (20) on the basis of the ascertained oscillating circuit parameter ($f_x$) of the modified oscillating circuit (20), the corresponding oscillating circuit parameter ($f_\emptyset$) of the non-modified oscillating circuit (20) and the impedance ($C_x$) introduced,

**characterized in that**
the additional impedance ($C_x$) is coupled into the oscillating circuit (20) in contactless manner,
the oscillating circuit parameter determining device (100) is adapted to determine the predetermined oscillating circuit parameter ($f_x$) of the modified oscillating circuit (LC'; 20') by contactless measurement,
the oscillating circuit parameter determining device (100) comprises the following means:

- means for exciting (S2.1) the modified oscillating circuit (LC'; 20') by means of an energy pulse;
- means for detecting (S2.2) an oscillation of the modified oscillating circuit (LC'; 20') in response to the excitation (S2.1);
- means for evaluating (S2.3) a detected oscillation of the modified oscillating circuit (LC'; 20') with respect to the predetermined oscillating circuit parameter ($f_x$).

9. The checking apparatus (1000) according to claim 8, **characterized in that** the impedance modifying device (200) is adapted to introduce a capacitance into the oscillating circuit (20) as the additional impedance ($C_x$).

**10.** The checking apparatus (1000) according to claim 9, **characterized in that** the impedance modifying device (200) is adapted to introduce the capacitance ($C_x$) in the form of a discrete component into the oscillating circuit (20).

**11.** The checking apparatus (1000) according to claim 9 or 10, **characterized in that** the impedance modifying device (200) is adapted to introduce the capacitance ($C_x$) into the oscillating circuit (20) **in that** an electrode (220) is approximated in a predetermined manner to the oscillating circuit (20).

**12.** The checking apparatus (1000) according to any of claims 8 to 11, **characterized in that** the oscillating circuit parameter determining device (100) is adapted to determine the self-resonant frequency of the oscillating circuit as the predetermined oscillating circuit parameter ($f_\varnothing$; $f_x$) of an oscillating circuit (20).

**13.** The checking apparatus (1000) according to any of claims 8 to 12, **characterized in that** the oscillating circuit parameter determining device (100) comprises:

- a pulse generator (110) which is adapted to contactlessly excite an oscillating circuit (20) arrangeable in the checking apparatus (1000) via an exciting coil (130) connected to the pulse generator (110);
- a measuring antenna (140) which is adapted to detect an oscillation of the oscillating circuit (20); and
- an evaluation device (160) which is connected to the measuring antenna (140) and is adapted to evaluate the oscillation detected by the measuring antenna (140) with respect to the predetermined oscillating circuit parameter ($f_x$).

**Revendications**

**1.** Procédé de détermination d'une inductance (L) d'un circuit oscillant (LC), comprenant les étapes :

- modification du circuit oscillant (LC; 20) par introduction (S1) d'une impédance supplémentaire ($C_x$) dans le circuit oscillant (LC; 20) ;
- détermination (S2) d'un paramètre prédéterminé de circuit oscillant ($f_x$) du circuit oscillant (LC'; 20') modifié par l'introduction de l'impédance, cependant que le paramètre de circuit oscillant ($f_x$) du circuit oscillant modifié (LC'; 20') est en relation prédéterminée avec l'inductance (L) du circuit oscillant non modifié (LC; 20) ;
- détermination (S3) de l'inductance (L) du circuit oscillant non modifié (LC; 20), sur la base du paramètre prédéterminé de circuit oscillant ($f_x$) du circuit oscillant modifié (LC'; 20'), du paramètre prédéterminé de circuit oscillant ($f_\varnothing$) du circuit oscillant non modifié (LC; 20) ainsi que de l'impédance introduite ($C_x$) ;

**caractérisé en ce que**
l'impédance supplémentaire ($C_x$) est, lors de l'introduction (S1.1), couplée sans contact dans le circuit oscillant (LC; 20), et que l'étape de la détermination (S2) du paramètre prédéterminé de circuit oscillant ($f_x$) comprend une mesure sans contact, et que
l'étape de la détermination (S2) du paramètre prédéterminé de circuit oscillant ($f_x$) du circuit oscillant modifié (LC'; 20') comprend les étapes partielles suivantes :

- excitation (S2.1) du circuit oscillant modifié (LC'; 20'), au moyen d'une impulsion d'énergie ;
- saisie (S2.2) d'une oscillation du circuit oscillant modifié (LC'; 20'), en réponse à l'excitation (S2.1) ;
- évaluation (S2.3) d'une oscillation saisie du circuit oscillant modifié (LC'; 20'), quant au paramètre prédéterminé de circuit oscillant ($f_x$).

**2.** Procédé selon la revendication 1, **caractérisé par** l'étape de la détermination du paramètre prédéterminé de circuit oscillant ($f_\varnothing$) du circuit oscillant non modifié (20), cependant que le paramètre de circuit oscillant est en relation prédéterminée avec l'inductance (L) du circuit oscillant non modifié (20) .

**3.** Procédé selon la revendication 1 ou 2, **caractérisé en ce que,** en tant que paramètre prédéterminé de circuit oscillant ($f_x$) du circuit oscillant modifié (20'), une fréquence de résonance propre ($f_x$) du circuit oscillant modifié (20') est déterminée, et que, en tant que paramètre correspondant de circuit oscillant ($f_\varnothing$) du circuit oscillant non modifié (20), pour la prédétermination de l'inductance (L), une fréquence de résonance propre ($f_\varnothing$) du circuit oscillant non modifié (20) est utilisée.

**4.** Procédé selon une des revendications de 1 à 3, **caractérisé en ce que,** à l'étape de la modification du circuit oscillant (20), en tant que l'impédance supplémentaire, une capacité ($C_x$) est introduite dans le circuit oscillant non modifié (20) .

5. Procédé selon la revendication 4, **caractérisé en ce que** la capacité ($C_x$) est introduite sous forme d'un composant discret dans le circuit oscillant non modifié (20) .

6. Procédé selon la revendication 4, **caractérisé en ce que** la capacité ($C_x$) est introduite dans le circuit oscillant non modifié (20), ce qui a lieu **en ce qu'**une électrode (220) est, de manière prédéterminée, approchée du circuit oscillant non modifié (20), cependant que l'électrode (220) agit, en concomitance avec une partie (22; 23) prédéterminée du circuit oscillant non modifié (20), comme un condensateur.

7. Procédé selon une des revendications de 4 à 6, **caractérisé en ce que** l'inductance (L) du circuit oscillant non modifié (20) est déterminée en vertu de la relation :

$$L = \frac{1}{C_x}\left[\left(\frac{1}{2\pi f_x}\right)^2 - \left(\frac{1}{2\pi f_\phi}\right)^2\right].$$

cependant que $L$ désigne l'inductance du circuit oscillant non modifié, $f_\phi$ la fréquence de résonance propre du circuit oscillant non modifié, $f_x$ la fréquence de résonance propre du circuit oscillant modifié, et $C_x$ la capacité introduite.

8. Dispositif de vérification (1000) destiné à la détermination de l'inductance (L) d'un circuit oscillant (20) et à la réalisation d'un procédé selon une des revendications précédentes, cependant que le dispositif de vérification (1000) comprend :

- un équipement de modification d'impédance (200) conçu pour modifier le circuit oscillant (20) par introduction d'une impédance supplémentaire ($C_x$) ;
- un équipement de détermination de paramètre de circuit oscillant (100) conçu pour déterminer un paramètre prédéterminé de circuit oscillant ($f_x$) du circuit oscillant modifié (20) ;
- un équipement de détermination d'inductance (300) conçu pour déterminer l'inductance (L) du circuit oscillant non modifié (20), sur la base du paramètre établi de circuit oscillant ($f_x$) du circuit oscillant modifié (20), du paramètre correspondant de circuit oscillant ($f_\phi$) du circuit oscillant non modifié (20) ainsi que de l'impédance introduite ($C_x$),

**caractérisé en ce que**
l'impédance supplémentaire ($C_x$) est couplée sans contact dans le circuit oscillant (20),
que l'équipement de détermination de paramètre de circuit oscillant (100) est conçu pour déterminer par mesure sans contact le paramètre prédéterminé de circuit oscillant ($f_x$) du circuit oscillant modifié (LC'; 20'),
que l'équipement de détermination de paramètre de circuit oscillant (100) comprend les moyens suivants :

- moyen d'excitation (S2.1) du circuit oscillant modifié (LC'; 20'), au moyen d'une impulsion d'énergie ;
- moyen de saisie (S2.2) d'une oscillation du circuit oscillant modifié (LC'; 20'), en réponse à l'excitation (S2.1) ;
- moyen d'évaluation (S2.3) d'une oscillation saisie du circuit oscillant modifié (LC'; 20'), quant au paramètre prédéterminé de circuit oscillant ($f_x$).

9. Dispositif de vérification (1000) selon la revendication 8, **caractérisé en ce que** l'équipement de modification d'impédance (200) est conçu pour introduire en tant qu'impédance supplémentaire ($C_x$) une capacité dans le circuit oscillant (20).

10. Dispositif de vérification (1000) selon la revendication 9, **caractérisé en ce que** l'équipement de modification d'impédance (200) est conçu pour introduire la capacité ($C_x$) sous forme d'un composant discret dans le circuit oscillant (20).

11. Dispositif de vérification (1000) selon la revendication 9 ou 10, **caractérisé en ce que** l'équipement de modification d'impédance (200) est conçu pour introduire la capacité ($C_x$) dans le circuit oscillant (20), ce qui a lieu **en ce qu'**une électrode (220) est, de manière prédéterminée, approchée du circuit oscillant (20).

**12.** Dispositif de vérification (1000) selon une des revendications de 8 à 11, **caractérisé en ce que** l'équipement de détermination de paramètre de circuit oscillant (100) est conçu pour déterminer en tant que le paramètre prédéterminé de circuit oscillant $(f_{\varnothing}, f_x)$ d'un circuit oscillant (20) la fréquence de résonance propre du circuit oscillant.

**13.** Dispositif de vérification (1000) selon une des revendications de 8 à 12, **caractérisé en ce que** l'équipement de détermination de paramètre de circuit oscillant (100) comprend :

- un générateur d'impulsions (110) conçu pour exciter sans contact, par l'intermédiaire d'une bobine excitatrice (130) raccordée au générateur d'impulsions (110), un circuit oscillant (20) pouvant être agencé dans le dispositif de vérification (1000) ;
- une antenne de mesure (140) conçue pour saisir une oscillation du circuit oscillant (20) ; et
- un dispositif d'évaluation (160) connecté à l'antenne de mesure (140) et conçu pour évaluer quant au paramètre prédéterminé de circuit oscillant $(f_x)$ l'oscillation saisie par l'antenne de mesure (140).

# FIG 1

# FIG 2

FIG 3

## FIG 4

| Modifizieren der Spule durch Einbringen einer zusätzlichen Impedanz in der Spule: | ~ S1 |
| Einbringen einer zusätzlichen Kapazität ~ S1.1 | |

| Bestimmen eines vorgegebenen Spulenparameters der modifizierten Spule | ~ S2 |

| Bestimmen der Induktivität der nicht modifizierten Spule, basierend auf dem Spulenparameter der modifizierten Spule, dem entsprechenden Spulenparameter der nicht modifizierten Spule und der eingebrachten Impedanz | ~ S3 |

## FIG 5

S2

| Anregen einer Spule mittels eines Energiepulses | ~ S2.1 |
| Erfassen einer Schwingung der Spule | ~ S2.2 |
| Auswerten der erfassten Schwingung hinsichtlich des vorgegebenen Spulenparameters | ~ S2.3 |

FIG 6

$$A = A_0 e^{-\delta t}$$

$A_m$

$A_{m+1}$

$$A = A_0 \exp(-\delta t) \cos \omega t$$

18

**IN DER BESCHREIBUNG AUFGEFÜHRTE DOKUMENTE**

**In der Beschreibung aufgeführte Patentdokumente**

- GB 581246 A
- DE 112006001115 T5
- US 20120264373 A1
- US 6236220 B1


**In der Beschreibung aufgeführte Nicht-Patentliteratur**

- **VON KLAUS FINKENZELLER.** RFID-Handbuch. Carl Hanser Verlag, 2012